# EUROPÄISCHE PATENTSCHRIFT

(11) **EP 0 950 212 B1**
(45) Veröffentlichungstag und Bekanntmachung des Hinweises auf die Patenterteilung: **13.03.2002**
(21) Anmeldenummer: 96944680.6
(22) Anmeldetag: 31.12.1996
(51) Int. Cl.: G03F 7/20

(54) **VERFAHREN ZUR ANSTEUERUNG EINER BELICHTUNGSVORRICHTUNG**
METHOD FOR CONTROLLING AN EXPOSURE DEVICE
PROCEDE POUR COMMANDER UN DISPOSITIF D'EXPOSITION

(43) Veröffentlichungstag der Anmeldung: 20.10.1999
(73) Patentinhaber: Lüllau, Friedrich, 21357 Bardowick (DE)
(72) Erfinder: LÜLLAU, Friedrich, D-21357 Bardowick (DE); MAYER, Claus, D-21379 Scharnebeck (DE)
(74) Vertreter: Vonnemann, Gerhard, Dr.-Ing.
(86) Internationale Anmeldenummer: EP9605869
(87) Internationale Veröffentlichungsnummer: WO9829782

(56) Entgegenhaltungen:
- EP-A- 0 549 993
- WO-A-95/22787
- DE-A- 4 121 509
- US-A- 4 441 791

## Beschreibung

Die Erfindung betrifft ein Verfahren zur Ansteuerung einer Belichtungsvorrichtung zum Belichten von Druckplatten als Abbild einer elektronisch gespeicherten Vorlage, wobei die Belichtungsvorrichtung zumindest eine Lichtquelle, eine Bilderzeugungseinheit und eine Abbildungsoptik umfaßt.

Außerdem betrifft die Erfindung eine zur Durchführung des Verfahrens geeignete Belichtungsvorrichtung mit einem verfahrbar ausgebildeten Belichtungskopf, der eine Lichtquelle, eine Bilderzeugungseinheit und eine Abbildungsoptik umfaßt.

Offsetdruckplatten werden heute noch zu über 90% über Filmvorlagen mit Hilfe der Kontaktkopiertechnik oder vereinzelt auch mit Projektionsanlagen belichtet. Das heißt, bevor eine Offsetdruckplatte belichtet werden kann, wird eine Filmvorlage erstellt. Das geschieht mit speziell dafür entwickelten Filmbelichtern und Filmentwicklungsmaschinen.

Der Verfahrensschritt zur Erstellung der Filmvorlage verlängert nachteilig den Zeit- und Kostenaufwand bei der Bebilderung von Offsetdruckplatten.

Aus der DE 41 21 509 Al ist eine für die Belichtung von Druckplatten geeignete Vorrichtung bekannt, die eine langgestreckte Lichtquelle in Form einer linearen Bogenlampe, eine Kollimatorlinse, einen aus elektronisch ansteuerbaren, beweglichen Mikrospiegeln bestehenden langgestreckten Lichtmodulator und eine Abbildungsoptik aufweist, wobei alle genannten Elemente ortsfest angeordnet sind. Die langgestreckte, linienhafte Form der Lichtquelle dient hier zur Erzielung einer höheren Lichtausbeute als bei punktförmigen Lichtquellen. Infolgedessen kann die ortsfeste Belichtungsanordnung aber nur einen sehr schmalen Streifen einer Druckplatte belichten. Zur vollständigen Belichtung wird daher die Druckplatte gegenüber der ortsfesten Belichtungsanordnung kontinuierlich verschoben. Damit die abgebildeten Daten relativ zu dem belichteten Material stationär bleiben, muß synchron mit der Bewegung der Druckplatte auch die Übertragung der Daten innerhalb der Spiegelanordnung verschoben werden.

Die bekannte Vorrichtung hat den Nachteil, daß sie wegen der kontinuierlichen Bewegung der Druckplatte nur streifenförmig belichten und daher nur einen schmalen Bereich der Mikrospiegelanordnung ausnutzen kann. Dies führt zu langen Gesamtbelichtungszeiten. Weiterhin kann wegen der begrenzten Länge der Mikrospiegelanordnung in der Regel nicht die gesamte Länge der Druckplatte gleichzeitig belichtet werden. Die Druckplatte muß vielmehr spaltenweise belichtet und zu diesem Zweck hin und hergefahren werden. Dafür ist es aber erforderlich, den ganzen schweren Tisch, auf dem die Druckplatte aufgespannt ist, mikrometergenau zu verschieben. Wegen der zu bewegenden Masse kann dies mit der erforderlichen Präzision nicht beliebig schnell geschehen. Daraus ergibt sich eine weitere Verlängerung der Gesamtbelichtungszeit.

Aus der WO 95/22787 ist eine Vorrichtung zur photomechanischen Herstellung strukturierter Oberflächen, insbesondere zum Belichten von Druckplatten bekannt, die einen verfahrbaren Belichtungskopf mit einer Lichtquelle, einer Bilderzeugungseinheit und einer Abbildungsoptik aufweist. Der verfahrbare Belichtungskopf ist kompakt aufgebaut und relativ leicht. Dadurch kann er mikrometergenau positioniert werden. Die Bilderzeugungseinheit besteht aus einem Flüssigkristallbildschirm, der zwischen zwei Polarisatoren angeordnet ist. Aus der genannten Druckschrift ist auch ein Belichtungsverfahren bekannt, bei dem die elektronisch gespeicherten Vorlagen in Teilbilder zerlegt und die Teilbilder nacheinander auf dem Flüssigkristallbildschirm dargestellt und derart auf die Druckplatte abgebildet werden, daß sie sich zu einem Gesamtabbild der Vorlage vereinen. Dazu wird der Belichtungskopf zwischen zwei Teilbelichtungen höchst präzise jeweils von einer zur nächsten Belichtungsposition gefahren. Zur Belichtung der gesamten Druckplatte muß aber eine große Zahl von Teilbildern belichtet werden. Dabei kann eine sehr hohe Gesamtbelichtungszeit entstehen.

Prinzipiell kann die Belichtungszeit verkürzt werden, indem für die Belichtung höhere Lichtintensitäten verwendet werden. Höhere Lichtintensitäten führen aber bei dem notwendig engen Aufbau des Belichtungskopfes zu einer nicht mehr tolerierbaren Wärmebelastung, insbesondere weil für die erforderliche Polarisierung des in den Flüssigkristallbildschirm fallenden Lichtes eine Polarisationsfolie verwendet wird. Derartige Polarisationsfilter lassen den einen Teil des einfallenden Lichtes mit der "richtigen" Polarisationsrichtung durch, während der verbleibende Teil mit der "falschen" Polarisationsrichtung absorbiert wird. Bei hohen Lichtintensitäten entsteht daher im Polarisationsfilter eine erhebliche Wärmemenge, die abgeführt werden muß, um eine Zerstörung des Polarisationsfilters zu vermeiden. Auch im Flüssigkristallbildschirm selbst und in der nachfolgenden zweiten Polarisationfolie entsteht Wärme aus absorbiertem Licht.

Insbesondere bei der Erstellung von Offsetdruckplatten für den Zeitungsdruck führt die sequentielle Belichtung bekannter Verfahren und Vorrichtungen zu nachteiligen zeitlichen Engpässen.

Aufgabe der Erfindung ist es ein Verfahren und eine Vorrichtung der eingangs genannten Art anzugeben, die bei verringerten Gesamtbelichtungszeiten qualitativ befriedigende Belichtungsergebnisse liefert.

Diese Aufgabe wird bei einem erfindungsgemäßen Verfahren durch die Merkmale des Anspruchs 1 gelöst.

Die Erfindung überträgt das im Zusammenhang mit einem präzisionsgesteuerten beweglichen Belichtungskopf bekannte Verfahren, das auf der Erzeugung flächiger Teilbilder mittels Flüssigkristallbildschirm basiert, auf eine ortsfeste Belichtungsanordnung, die auf der linienhaften Bilderzeugung mittels Mikrospiegeln beruht. Dafür wird in einem ersten Erfindungsschritt die ortsfeste Belichtungseinrichtung als beweglicher Belichtungskopf ausgestaltet, in einem zweiten Erfindungsschritt die quasi lineare Mikrospiegelanordnung durch eine wirklich flächige ersetzt und in einem dritten Erfindungsschritt die elektronische Ablaufsteuerung für die Bewegung des Belichtungskopfes und die Belichtung der Teilbilder übertragen. Dabei führen die Hinweise der DE 41 21 509 A1 im ersten Absatz ihrer Beschreibungseinleitung den Fachmann eher weg von der Verwendung zweidimensionaler Lichtmodulatoren. Wenn der Fachmann im umgekehrten Fall von der aus der WO 95/22787 bekannten Vorrichtung und dem zugehörigen Verfahren ausgeht, gelangt er durch einfache Übernahme der aus der DE 41 21 509 A1 bekannten, ortsfesten Belichtungsanordnung mit Mikrospiegeln noch keineswegs zum Erfindungsgegenstand. Auch ein einfaches Ersetzen des Flüssigkristallbildschirms durch die lineare Mikrospiegelanordnung führt nicht direkt zur Erfindung. Dazu wäre eine wirklich flächige, zweidimensionale Mikrospiegelanordnung erforderlich, die zudem ganz anders angesteuert werden muß als die lineare Anordnung. Darüberhinaus kann die Mikrospiegelanordnung nicht einfach an die Stelle des Flüssigkristallbildschirms gesetzt werden, da sie das Licht reflektiert und nicht transmittiert. Weiterhin muß ein Absorber für das nicht verwendbare reflektierte Licht vorgesehen sein, während die Polarisatoren nicht mehr benötigt werden.

Hohe Verfahrgeschwindigkeiten des Belichtungskopfes erreicht man, wenn als Antrieb zur Erzeugung einer Bewegung der Bilderzeugungseinheit mindestens ein elektrischer Linearantrieb verwendet wird. Die Belichtungszeiten können sich an die auf diese Weise verkürzten Positionierzeiten ohne Wartezeit anschließen, weil Elastizitäts-, Spiel-, Reibungseffekte und Eigenschwingungen durch den elektrischen Linearantrieb weitgehend vermieden sind.

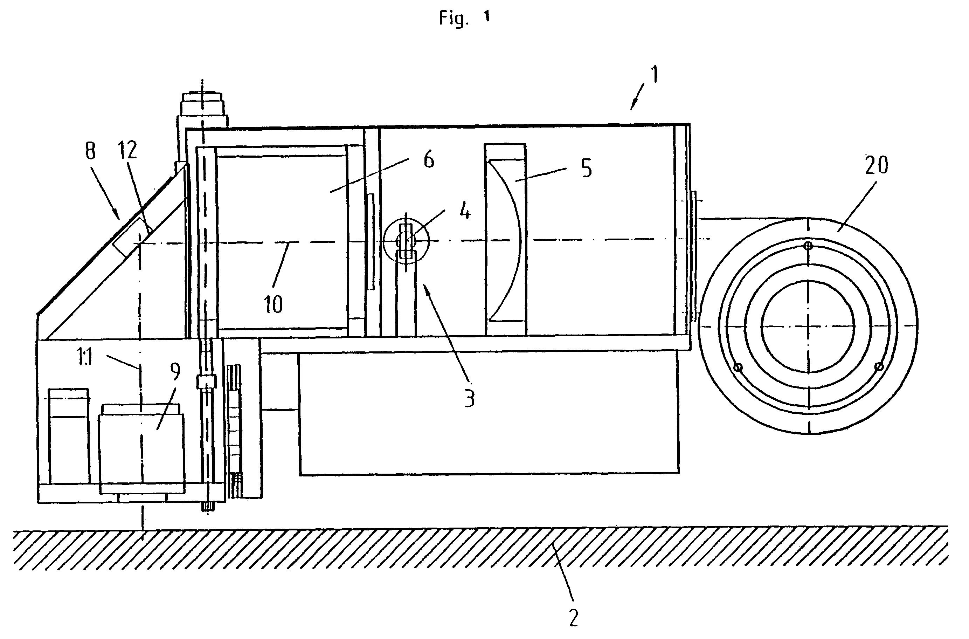

Da Offset-Druckplatten eine Welligkeit aufweisen können, die teilweise größer als 2 mm ist, und diese Unebenheiten auch unterschiedlich verteilt sind, muß durch entsprechend klein gewählte Blenden eine ausreichende Tiefenschärfe der Abbildung erreicht werden. Durch die geringe Lichtausbeute jedoch verlängern sich die Belichtungszeiten des Teilbildes. Zur Verkürzung dieser Belichtungszeiten ist vorgesehen, daß vor jeder Abbildung eines Teilbildes eine Messung des Abstandes der Bilderzeugungseinheit bzw. des Belichtungskopfes zu der zu belichtenden Oberfläche erfolgt und Abweichungen von einem voreingegebenen Wert automatisch korrigiert werden. Auf diese Weise kann man mit einer überraschend geringen Tiefenschärfe auch bei welligen Platten eine hohe Abbildungsqualität bei kurzen Belichtungszeiten erzielen. Die Korrektur kann vorzugsweise durch ein Verfahren des gesamten Belichtungskopfes erfolgen. Auf diese Weise lassen sich auch unterschiedlich dicke Offset-Druckplatten belichten. Es kann auch die Brennweite entsprechend korrigiert werden, was jedoch zu Abbildungsfehlern führen kann.

Auch die qualitativ anspruchsvollsten Druckvorlagen lassen sich mit dem Verfahren herstellen, wenn die Bilderzeugungseinheit verkleinert abgebildet wird. Durch die Verkleinerung lassen sich Auflösungen von beispielsweise 2540 DPI erzielen. Allerdings ist dadurch auch die Vorlage in entsprechend viele Teilbilder aufzugliedern, die nacheinander belichtet und zu der Gesamtvorlage zusammengefügt werden. Durch die so erhöhte Anzahl von Einzelbelichtungen steigt die Gesamtbelichtungszeit erheblich.

Wenn eine Positionierung der Teilbilder mit einer Genauigkeit von besser als 5 um, insbesondere besser als 2 µm erfolgt, schließen sich die einzelnen Teilbilder lückenlos aneinander.

Es kommt vor, daß nicht alle Teilbilder auch tatsächlich Bildinformationen enthalten. Erfindungsgemäß werden deshalb nur Teilbilder auf die zu belichtende Oberfläche übertragen, die Bildinhalte aufweisen. Aufgrund der verringerten Anzahl von Teilbildern verkürzt sich dadurch die gesamte Belichtungszeit in etwa proportional zu der Summe von Teilbildern ohne Bildinhalt. Dabei fährt der Belichtungskopf auf einem meanderförmigen Weg jede Position eines Teilbildes an.

Die für die Restmenge noch erforderliche gesamte Belichtungszeit kann weiter herabgesetzt werden, wenn jedem Teilbild ein erster Datensatz für seinen Bildinhalt und ein zweiter Datensatz für seine Position zugeordnet wird, und nur zusammengehörige Datensätze mit Bildinhalt zur Erzeugung einer Abfolge von Steuerdatensätzen zur Übergabe an eine numerische Steuerung verwendet werden. Dadurch können auch die zwischen den einzelnen Belichtungszeiten erforderlichen Zeiten für den Positionswechsel zwischen zwei Belichtungsorten verringert werden.

Die Zeit für die Offsetdruckplattenerstellung kann durch eine weitere Wegreduzierung verkürzt werden, indem die Menge der zweiten Datensätze so sortiert wird, daß sich eine möglichst geringe Summe von Einzelabständen zwischen den Positionen der Teilbilder ergibt und die Datensätze in dieser Reihenfolge an die numerische Steuerung übergeben werden. Auf diese Weise wird das Gesamtbild mit dem kürzesten Verfahrweg erstellt.

Eine gleichmäßige Abbildungsqualität über der gesamten Fläche der Vorlage erzielt man, wenn zur Abbildung eine Lichtquelle verwendet wird, deren Lichtstrom gemessen wird und Abweichungen von einem vorgegebenen Lichtstrom automatisch korrigiert werden.

Diese Korrektur kann entweder durch Verändern der Belichtungszeit oder durch Verändern einer elektrischen Versorgung der Lichtquelle erfolgen.

Die gesamte Belichtungszeit einer Vorlage kann dadurch verringert werden, daß unter Verwendung mehrerer Belichtungsköpfe mehrere Teilbilder gleichzeitig abgebildet werden.

Kollisionen von verschiedenen Belichtungsköpfen vermeidet man dadurch, daß eine Relativbewegung mehrerer Abbilder zum Musterträger sychron erfolgt. Der Abstand der hintereinander gereihten, gleichzeitig abgebildeten Teilbilder bleibt dabei vorteilhaft konstant. Da die Wahrscheinlichkeit sinkt, daß beide Belichtungsköpfe gleichzeitig keine Bildinhalte aufweisen, und eine Belichtungsposition gleichzeitig übersprungen werden kann, ist vorteilhaft, wenn in einem vorgegebenen Grenzbereich, sich die Belichtungsköpfe unabhängig voneinander bewegen können.

Dadurch, daß ein Abstand zwischen zwei gleichzeitig belichteten Abbildern veränderbar ist, können Vorlagen mit unterschiedlichen Auflösungen mit derselben Belichtungsvorrichtung belichtet werden. Der Abstand zweier gleichzeitiger Abbildungen beträgt ein ganzzahliges Vielfaches der Einzelbildabmessungen.

Eine größere Gleichmäßigkeit der Übergänge erreicht man dadurch, daß die Teilbilder sich überlappend abgebildet werden. Im Bereich der Überlappungen vom Bilderrand zum Inneren hin wird der Schwärzungsgrad linear ansteigend angepaßt, so daß sich durch die Überlagerung eine dem Originalbild entsprechende Verteilung ergibt.

Eine zur Durchführung des erfindungsgemäßen Verfahrens besonders geeignete Belichtungsvorrichtung zeichnet sich dadurch aus, daß eine Meß- und Regelvorrichtung für die Messung und Regelung des Abstandes der Bilderzeugungseinheit oder des Belichtungskopfes zu der zu belichtenden Oberfläche vorgesehen ist. Vor jeder Belichtung wird mittels der Meßvorrichtung der Abstand zu der zu belichtenden Oberfläche ermittelt. Als Meßvorrichtung sind beispielsweise bekannte Lasermeßvorrichtungen geeignet. Dabei wird der Abstand durch interferometrische Längenmessung bestimmt. Die Abstandsmessung kann jedoch auch durch bekannte akustische oder optische Meßverfahren ermittelt werden. Durch Vergleiche mit einem vorgegebenen Sollwert wird eine Stellgröße bestimmt, die dann über ein entsprechendes Stellglied den Abstand nachregelt. Dies kann beispielsweise auch durch Verstellen der Brennweite oder durch motorische Höhenverstellung des Belichtungskopfes oder von Teilen desselben erfolgen. Aufgrund der erfindungsgemäß vorgesehenen Regelung kann mit Lichtquellen gearbeitet werden, die einen großen Raumwinkel überstreichen, so daß aufgrund der hohen Lichtausbeute kurze Belichtungszeiten möglich sind.

Besonders hohe Verfahrgeschwindigkeiten und Beschleunigungen werden dadurch erzielt, daß nicht die Druckplatte mitsamt einer notwendigen schweren Aufspannplatte, sondern stattdessen nur der Belichtungskopf bewegt wird. Es können so mehr als zehn Teilbilder in der Sekunde positioniert und belichtet werden.

Die gesamte Vorlage wird mit gleichbleibender Qualität über die gesamte Fläche abgebildet, wenn ein Sensor zur Messung des Lichtstromes und ein Regelkreis zur Korrektur von Abweichungen des Lichtstromes von einem Sollwert vorgesehen ist. Dadurch können auch langsame Änderungen der Lichtausbeute keinen Einfluß auf das Arbeitsergebnis ausüben.

Beispielsweise können Veränderungen, die über einen längeren Zeitraum sich bemerkbar machen, dadurch korrigiert werden, daß im Regelkreis eine Stellvorrichtung zur Veränderung einer Belichtungszeit vorgesehen ist. Dabei ist der Sensor zur Messung des Lichtstromes vorzugsweise in der Nähe der zu belichtenden Oberfläche angeordnet, so daß der auftreffende Lichtstrom vor Beginn der Belichtung der Teilbilder einmal erfaßt wird.

Kurzfristige Änderungen, die beispielsweise durch Schwankungen der Netzversorgungsspannungen entstehen, können ausgeglichen werden, wenn im Regelkreis eine Stellvorrichtung zur Veränderung des Lichtstromes vorgesehen ist. Hierbei wird der Lichtsensor vorzugsweise in der Nähe der Lichtquelle angeordnet oder direkt die Versorgungsspannung gemessen. Durch bekannte Schaltungen läßt sich somit beispielsweise die Versorgungsspannung konstant halten.

Ein häufiges Ein- und Ausschalten der Lampe kann vermieden werden, wenn ein Verschluß zum Schalten des Lichtstromes vorgesehen ist. Dadurch erhöht sich die Lebensdauer der Lampe.

Wenn die Bilderzeugungseinheit selbst als Belichtungsverschluß wirkend ausgebildet ist, kann mit Vorteil auf einen gesondert ausgebildeten Belichtungsverschluß verzichtet werden.

Ein besonders vorteilhaftes dynamisches Verhalten der Gesamtvorrichtung ergibt sich, wenn der Antrieb zur Erzeugung der Bewegung des Belichtungskopfes als Linearantrieb ausgebildet ist. Solche Antriebe weisen eine hohe Positioniergenauigkeit auf, die besser als 2 um ist.

Die Gesamtvorlage läßt sich in noch kürzerer Zeit fertigstellen, indem mehrere Belichtungsköpfe auf einer Achse angeordnet sind.

Eine besonders günstige Konstruktion ergibt sich, wenn jedem Belichtungskopf ein eigener Linearantrieb zugeordnet ist und für die andere Achse ein gemeinsamer Linearantrieb für alle Belichtungsköpfe vorgesehen ist. Dabei nimmt man in Kauf, daß in einer Achse die Feststellgeschwindigkeit etwas geringer ist, als die der beiden Köpfe in die andere Richtung. Dies beeinflußt die Gesamtbelichtungszeit nur geringfügig. Dadurch, daß jeder Belichtungskopf in der anderen Richtung seinen eigenen Linearantrieb aufweist, kann auch kurzfristig auf unterschiedliche Auflösungen umgeschaltet werden, indem die Belichtungsköpfe so verfahren werden, daß sich ein größerer oder kleinerer Zwischenraum ergibt.

Die Erfindung wird in einer bevorzugten Ausführungsform unter Bezugnahme auf die Zeichnung beschrieben, der weitere vorteilhafte Einzelheiten zu entnehmen sind.

Die einzige Figur zeigt einen Schnitt durch einen Belichtungskopf einer erfindungsgemäßen Belichtungsvorrichtung in einer schematischen Darstellung.

In der Figur erkennt man einen Belichtungskopf 1, der mittels einer nicht gezeigten Vorrichtung auf einer Unterlage 2 motorisch verfahrbar angeordnet ist. Der Belichtungskopf 1 besitzt eine Lichtquelle 3, die aus einer Metallhalogenitlampe 4, einem Reflektor 5 und einem Kollimator 6 besteht. Der Kollimator 6 enthält eine nicht gezeigte Linsenoptik, die das für die Belichtung vorgesehene Licht weitgehend parallel ausrichtet. Weiterhin umfaßt der Belichtungskopf 1 eine Bilderzeugungseinheit 8 und eine Abbildungsoptik 9, mittels derer die in der Bilderzeugungseinheit 8 erzeugte Bildvorlage auf eine nicht gezeigte Druckplatte auf der Unterlage 2 im verkleinerten Maßstab projiziert und abgebildet werden kann.

Für eine bessere Handhabbarkeit ist der Belichtungskopf 1 im wesentlichen liegend über der Unterlage 2 angeordnet. Das für die Belichtung verwendete Licht hat ursprünglich einen Strahlengang mit einer horizontalen optischen Achse 10. Für die Abbildung auf der Unterlage 2 ist eine optische Achse 11 der Abbildungsoptik 9 vertikal ausgerichtet. Für die Umlenkung des Strahlengangs aus der Horizontalen in die Vertikale ist eine spiegelnde Oberfläche 12 der Bilderzeugungseinheit 8 vorgesehen. Für eine ausreichende Wärmeabfuhr sorgt ein seitlich am Gehäuse des Belichtungskopfes 1 angebrachtes Gebläse 20.

Im Strahlengang nach der Metallhalogenitlampe 4 könnte mit Vorteil ein UV-durchlässiger Filter oder ein UV-durchlässiges optisches Element angeordnet sein, das einen wesentlichen Teil der Lichtintensität im nicht nutzbaren Spektralbereich aus dem Strahlengang herausnimmt und dabei die Wärmebelastung der nachfolgenden optischen Elemente verringert.

Die Bilderzeugungseinheit 8 besteht aus einem Mikrochip mit rasterförmig angeordneten, elektronisch individuell ansteuerbaren, beweglichen Mikrospiegeln. Die Spiegel können durch elektronische Ansteuerung entweder so ausgerichtet sein, daß sie den Strahlengang des einfallenden Lichtes aus der Horizontalen in die Vertikale und damit in die Abbildungsoptik 9 hineinlenken, oder so ausgerichtet sein, daß das reflektierte Licht gerade seitlich an der Abbildungsoptik 9 vorbeigelenkt wird. Durch individuelles Ausrichtung der Mikrospiegel in bestimmten Flächenbereichen kann eine Bildvorlage erzeugt werden, die mittels der Abbildungsoptik 9 auf die Druckplatte projiziert werden kann. Dabei wird fast das gesamte für die Abbildung nicht verwendete Licht aus dem Strahlengang herausgelenkt.

Eine auf die Druckplatte bzw die Unterlage 2 abzubildende Vorlage ist digital in einem zeichnerisch nicht dargestellten Computer gespeichert. Mittels geeigneter Programme wird die Vorlage in Teilbilder zerlegt und in bekannter Weise über eine Steuerleitung an die Mikrospiegelanordnung weitergeleitet, der hier als Bilderzeugungseinheit 8 dient.

Zur Belichtung wird die Lichtquelle 4 für die benötigte Lichtmenge kurzfristig mit ausreichendem Strom versorgt. Diese Betriebsweise, unter Verwendung entsprechender Blitzlampen, weist den Vorteil einer gegenüber Dauerbetrieb verringerten Verlustleistung auf.

Alternativ kann jedoch auch ein Verschluß vorgesehen werden, der mit einer entsprechenden Steuereinheit die Belichtungszeit bestimmt.

Nach der Belichtung eines Teilbildes wird der Belichtungskopf 1 gegenüber der Unterlage 2 um das dem Teilbildausschnitt entsprechende Rastermaß verschoben. Die Belichtung des nächsten Teilbildes erfolgt in der Weise, daß sich die Teilbilder lückenlos aneinander anschließen und sich in ihren Bildinhalten zum Gesamtbild ergänzen.

Auf diese Weise besteht die Möglichkeit mit Hilfe moderner Datenverarbeitungsanlagen erstellte Vorlagen direkt auf einem Druckträger abzubilden. Die Kosten zur Erstellung eines Filmes und der damit verbundene Zeitaufwand entfallen.

Die als Lichtquelle 3 verwendete Metallhalogenitlampe 4 muß eine gewisse Zeit betrieben werden, bis sie ihre volle Leistung erreicht. Der von der Lichtquelle 3 ausgehende Lichtstrom kann daher mittels eines Lichtsensors gemessen und über eine Signalleitung einer Ansteuerungselektronik übermittelt werden. Entsprechend der gemessenen Stärke des Lichtstromes wird die Belichtungszeit vorgegeben und ein Verschluß für die Dauer der Belichtungszeit geöffnet. Nach Belichten eines ersten Teilbildes auf die Druckplatte wird der Belichtungskopf 1 um eine Bildteilung verschoben und ein weiteres Teilbild belichtet.

Von einer Abstandsmessung, die beispielsweise als Laser-Entfernungsmeßgerät ausgebildet ist, erhält die Ansteuerungselektronik den aktuellen Abstand zur Druckplatte. Bei Abweichungen von einem vorher eingestellten Sollwert wird dann ein entsprechender Stellbefehl zur Funktionsgruppe der Abstandsregelung oder Brennweitenregelung generiert, so daß dann der Abstand oder die Brennweite entsprechen korrigiert wird, um eine möglichst große Schärfe der Abbildung zu erzielen. Entsprechend wird das Ergebnis einer Belichtungsmessung mit einem voreingestellten Sollwert verglichen und ein entsprechendes Korrektursignal an eine Verschlußregelung oder Lichtquellenregelung generiert. Die momentane Lage des Belichtungskopfes kann von einem Meßkopf übermittelt werden.

### Bezugszeichenliste

- 1: Belichtungskopf
- 2: Unterlage
- 3: Lichtquelle
- 4: Metallhalogenitlampe
- 5: Reflektor
- 6: Kollimator
- 7 8: Bilderzeugungseinheit
- 9: Abbildungsoptik
- 10: optische Achse
- 11: optische Achse
- 12: Oberfläche
- 13 14 15 16 17 18 19 20: Gebläse

## Patentansprüche

1. Verfahren zur Ansteuerung einer Belichtungsvorrichtung zum Belichten von Druckplatten als Abbild einer elektronisch gespeicherten Vorlage, wobei die Belichtungsvorrichtung zumindest eine Lichtquelle (3), eine aus rasterförmig angeordneten, elektronisch individuell ansteuerbaren, beweglichen Mikrospiegeln bestehende Bilderzeugungseinheit (8) und eine Abbildungsoptik (9) zum verkleinerten Abbilden der Bilderzeugungseinheit (8) auf die Druckplatte umfaßt, wobei die Vorlage auf elektronischen Wegen in zweidimensionale Teilbilder zerlegt wird, daß die Teilbilder nacheinander, jedes Teilbild aber mit seiner gesamten Fläche gleichzeitig mittels der Bilderzeugungseinheit (8) dargestellt und aufeinanderfolgende Teilbelichtungen der zu belichtenden Oberfläche ausgeführt werden, indem ein mit der Lichtquelle (3), der Bilderzeugungseinheit (8) und der Abbildungsoptik (9) versehener Belichtungskopf (1) zwischen zwei Teilbelichtungen jeweils von einer zur nächsten Belichtungsposition fährt und dort zum Belichten anhält, so daß sich die einzelnen Teilabbilder zu einem Gesamtabbild der elektronisch gespeicherten Vorlage wieder vereinigen, wobei als Antrieb zur Erzeugung einer Bewegung der Bilderzeugungseinheit mindestens ein elektrischer Linearantrieb verwendet wird und eine Positionierung der Teilbilder mit einer Genauigkeit von besser als 5 µm erfolgt, insbesondere besser als 2 µm, und wobei vor jeder Abbildung eines Teilbildes eine Messung des Abstandes der Bilderzeugungseinheit (8) zu der zu belichtenden Oberfläche erfolgt und Abweichungen von einem voreingegebenen Wert automatisch korrigiert werden.

2. Verfahren nach Anspruch 1, **dadurch gekennzeichnet, daß** durch eine Auswerteschaltung oder -software der Bildinhalt eines jeden Teilbildes geprüft wird, ob Bildinformationen darin enthalten sind, und in Abhängigkeit von dieser Prüfung eine Abbildung des Teilbildes auf der zu belichtenden Oberfläche erfolgt.

3. Verfahren nach Anspruch 1 oder 2, **dadurch gekennzeichnet, daß** jedem Teilbild ein erster Datensatz für seinen Bildinhalt und ein zweiter Datensatz für seine Position zugeordnet wird, und daß nur zusammengehörige Datensätze mit Bildinhalt zur Erzeugung einer Abfolge von Steuerdatensätzen zur Übergabe an eine numerische Steuerung verwendet werden.

4. Verfahren nach Anspruch 3, **dadurch gekennzeichnet, daß** die Menge der zweiten Datensätze so sortiert wird, daß sich eine möglichst geringe Summe von Einzelabständen zwischen den Positionen der Teilbilder ergibt und die Datensätze in dieser Reihenfolge an die numerische Steuerung übergeben werden.

5. Verfahren nach einem der Ansprüche 1 bis 4, d adurch **gekennzeichnet**, daß zur Abbildung eine Lichtquelle (3) verwendet wird, deren Lichtstrom gemessen wird und Abweichungen von einem vorgegebenen Lichtstrom automatisch korrigiert werden.

6. Verfahren nach Anspruch 5, **dadurch gekennzeichnet, daß** die Korrektur durch Verändern der Belichtungszeit erfolgt.

7. Verfahren nach Anspruch 5, **dadurch gekennzeichnet, daß** die Korrektur durch Verändern einer elektrischen Versorgung der Lichtquelle (3) erfolgt.

8. Verfahren nach einem der vorhergehenden Ansprüche, **dadurch gekennzeichnet, daß** unter Verwendung mehrerer Belichtungsköpfe (1) mehrere Teilbilder gleichzeitig abgebildet werden.

9. Verfahren nach Anspruch 8, **dadurch gekennzeichnet, daß** eine Relativbewegung mehrerer Abbilder zu der zu belichtenden Unterlage sychron erfolgt.

10. Verfahren nach Anspruch 8 oder 9, **dadurch gekennzeichnet, daß** ein Abstand zwischen zwei gleichzeitig belichteten Abbildern veränderbar ist.

11. Verfahren nach einem der vorhergehenden Ansprüche, **dadurch gekennzeichnet, daß** die Teilbilder sich überlappend abgebildet werden.

12. Belichtungsvorrichtung zur Durchführung eines Verfahrens nach einem der vorhergehenden Ansprüche, mit einem verfahrbar ausgebildeten Belichtungskopf (1), der eine Lichtquelle (3), eine aus rasterförmig angeordneten, elektronisch individuell ansteuerbaren, beweglichen Mikrospiegeln bestehende Bilderzeugungseinheit (8) und eine Abbildungsoptik (9) umfaßt, wobei eine Meß- und Regelvorrichtung für die Messung und Regelung des Abstandes der Bilderzeugungseinheit (8) oder des Belichtungskopfes (1) zu der zu belichtenden Oberfläche (2) vorgesehen ist und wobei der Antrieb zur Erzeugung der Bewegung des Belichtungskopfes (1) als Linearantrieb ausgebildet ist.

13. Vorrichtung nach Anspruch 12, **dadurch gekennzeichnet, daß** ein Sensor zur Messung des Lichtstromes und ein Regelkreis zur Korrektur von Abweichungen des Lichtstromes von einem Sollwert vorgesehen ist.

14. Vorrichtung nach Anspruch 13, **dadurch gekennzeichnet, daß** im Regelkreis eine Stellvorrichtung zur Veränderung einer Belichtungszeit vorgesehen ist.

15. Vorrichtung nach Anspruch 13 oder 14, **dadurch gekennzeichnet, daß** im Regelkreis eine Stellvorrichtung zur Veränderung des Lichtstromes vorgesehen ist.

16. Vorrichtung nach einem der Ansprüche 12 bis 15, **dadurch gekennzeichnet, daß** ein Verschluß zum Schalten des Lichtstromes vorgesehen ist.

17. Vorrichtung nach Anspruch 16, **dadurch gekennzeichnet, daß** die Bilderzeugungseinheit (8) als Belichtungsverschluß wirkend ausgebildet ist.

18. Vorrichtung nach einem der Ansprüche 12 bis 17, **dadurch gekennzeichnet, daß** mehrere Belichtungsköpfe (1) auf einer Achse angeordnet sind.

19. Vorrichtung nach Anspruch 18, **dadurch gekennzeichnet, daß** jedem Belichtungskopf (1) ein eigener Linearantrieb zugeordnet ist und für die andere Achse ein gemeinsamer Linearantrieb für alle Belichtungsköpfe vorgesehen ist.

## Claims

1. Method for controlling an exposure device for exposing printing plates as a replica of an electronically stored master, wherein the exposure device comprises at least one light source (3), an image-generating unit (8) comprising electronically individually controllable, movable micromirrors disposed in raster fashion and imaging optics (9) for the reduced imaging of the image-generating unit (8) on the printing plate, wherein the master is broken down electronically into two-dimensional part images, so that the part images are displayed one after another, but the entire area of each part image is displayed simultaneously by means of the image-generating unit (8), and consecutive part exposures of the surface to be exposed are performed in that an exposure head (1) provided with the light source (3), the image-generating unit (8) and the imaging optics (9) travels in each case between two part exposures from one exposure position to the next and stops at the latter for the exposure so that the individual part replicas are recombined to form an overall image of the electronically stored master, wherein at least one electrical linear drive is used as drive for generating a movement of the image-generating unit and the part images are positioned with a precision of better than 5 µm, in particular better than 2 µm, and wherein, prior to every imaging of a part image, the distance of the image-generating unit (8) from the surface to be exposed is measured and deviations from a previously adjusted value are automatically corrected.

2. Method according to Claim 1, **characterized in that**, by means of an evaluation circuit or evaluation software, the picture content of each part image is tested to see whether items of image information are contained therein, and the part image is imaged on the surface to be exposed depending on this test.

3. Method according to Claim 1 or 2, **characterized in that** every part image is assigned a first data record for its image content and a second data record for its position, and **in that** only associated data records with image content are used to generate a sequence of control data records for transfer to a numerical control system.

4. Method according to Claim 3, **characterized in that** the population of the second data record is sorted in such a manner as to result in as small a sum as possible of individual distances between the positions of the part images and the data records are transferred in this sequence to the numerical control.

5. Method according to one of Claims 1 to 4, **characterized in that** a light source (3) is used for imaging whose luminous flux is measured and deviations from a specified luminous flux are automatically corrected.

6. Method according to Claim 5, **characterized in that** altering the exposure time makes the correction.

7. Method according to Claim 5, **characterized in** the correction is made by altering an electrical supply of the light source (3).

8. Method according to one of the preceding claims, **characterized in that** a plurality of part images is imaged simultaneously using a plurality of exposure heads (1).

9. Method according to Claim 8, **characterized in that** a relative movement of a plurality of replicas takes place synchronously with respect to the base to be exposed.

10. Method according to Claim 8 or 9, **characterized in that** a distance between two simultaneously exposed replicas is variable.

11. Method according to one of the preceding claims, **characterized in that** the part images are imaged in an overlapping manner.

12. Exposure device for performing a method according to one of the preceding claims, having a displaceably designed exposure head (1) that comprises a light source (3), an image-generating unit (8) comprising electronically individually controllable, movable micromirrors disposed in raster fashion and imaging optics (9), wherein a measuring and control device is provided for measuring and controlling the distance of the image-generating unit (8) or of the exposure head (1) from the surface (2) to be exposed and wherein the drive for generating the movement of the exposure head (1) is designed as a linear drive.

13. Device according to Claim 12, **characterized in that** a sensor is provided for measuring the luminous flux and a control circuit is provided for correcting deviations in the luminous flux from a setpoint value.

14. Device according to Claim 13, **characterized in that** a control device is provided in the control circuit for altering an exposure time.

15. Device according to Claim 13 or 14, **characterized in that** a control device for altering the luminous flux is provided in the control circuit.

16. Device according to one of Claims 12 to 15, **characterized in that** a shutter is provided for switching the luminous flux.

17. Device according to Claim 16, **characterized in that** the image-generating unit (8) is designed to act as an exposure shutter.

18. Device according to one of Claims 12 to 17, **characterized in that** a plurality of exposure heads (1) is disposed on one axis.

19. Device according to Claim 18, **characterized in that** every exposure head (1) is assigned its own linear drive and a common linear drive for all the exposure heads is provided for the other axis.

## Revendications

1. Procédé de commande d'un dispositif d'exposition pour exposer des plaques d'impression comme images d'un modèle mémorisé de manière électronique,
le dispositif d'exposition comprend au moins une source lumineuse (3), une unité de génération d'image (8) formée de micromiroirs mobiles, commandés individuellement de manière électronique, répartis suivant une trame,
et une optique d'image (9) pour réduire les images des unités de génération d'image (8) sur la plaque d'impression,
le modèle étant décomposé de manière électronique en image partielle à deux dimensions,
les images partielles sont présentées chacune avec toute sa surface, simultanément à l'aide de l'unité de génération d'image (8) et
on effectue ensuite des expositions partielles de la surface à exposer en déplaçant une tète d'exposition (1) comprenant la source lumineuse (3), l'unité générant l'image (8) et l'optique de copie (9), entre deux expositions partielles, chaque fois d'une position d'exposition à la suivante et s'y arrête pour que les différentes images partielles se combinent de nouveau pour former l'image globale du modèle à mémorisation électronique,
l'entraînement pour créer le mouvement de l'unité de génération d'image étant au moins un moteur linéaire électrique et
on positionne les images partielles avec une précision supérieure à 5 µm, notamment supérieure à 2 µm et avant chaque exposition d'une image partielle on mesure la distance de l'unité générant l'image (8) et la surface superficielle à exposer et
on corrige automatiquement les déviations par rapport à une valeur prédéterminée.

2. Procédé selon la revendication 1,
**caractérisé en ce qu'**
avec un circuit d'exploitation ou un programme on vérifie le contenu des images de chaque image partielle, pour voir si elle contient des informations et en fonction de ce contrôle on fait une copie de l'image partielle sur la surface à exposer.

3. Procédé selon l'une quelconque des revendications 1 ou 2,
**caractérisé en ce qu'**
à chaque partie d'image on associe un premier jeu de données pour un contenu d'image et un second jeu de données pour sa position,
et on utilise seulement des jeux de données cohérents avec le contenu d'image pour générer une suite de jeux de données de commande pour contrôler le transfert à une commande numérique.

4. Procédé selon la revendication 3,
**caractérisé en ce qu'**
on classe la quantité des seconds jeux de données pour avoir un nombre aussi réduit que possible de distances séparées entre les différentes positions des images partielles et que les jeux de données soient transmis à la commande numérique.

5. Procédé selon l'une quelconque des revendications 1 à 4,
**caractérisé en ce que**
pour effectuer la copie, on utilise une source lumineuse dont le flux lumineux est mesuré et corrigé pour corriger automatiquement les variations du flux lumineux.

6. Procédé selon la revendication 5,
**caractérisé en ce que**
la correction se fait par changement du temps d'exposition.

7. Procédé selon la revendication 5,
**caractérisé en ce que**
la correction se fait par changement de l'alimentation électrique de la source lumineuse (3).

8. Dispositif selon l'une quelconque des revendications précédentes,
**caractérisé en ce qu'**
en utilisant plusieurs têtes d'exposition (1) on peut générer en même temps plusieurs images partielles.

9. Procédé selon la revendication 8,
**caractérisé en ce que**
le mouvement relatif de plusieurs images modèles vers le support à éclairer se fait en synchronisme.

10. Procédé selon l'une quelconque des revendications 8 ou 9,
**caractérisé en ce que**
la distance entre deux images éclairées de la même manière est variable.

11. Procédé selon l'une quelconque des revendications précédentes,
**caractérisé en ce que**
les images partielles sont réalisées de façon à se chevaucher.

12. Dispositif d'exposition pour la mise en oeuvre d'un procédé selon l'une quelconque des revendications précédentes, comprenant une tête d'éclairage (1), mobile, ayant une source lumineuse (3) et des micromiroirs mobiles, commandés individuellement de manière électronique, et installés selon une trame, pour former l'unité générant l'image (8) et une optique de copie (9),
le dispositif de mesure et de réglage pour la mesure et la régulation de la distance de l'unité formant les images (8) ou de la tête d'exposition (1) est prévu pour la surface (2) à exposer et le moteur qui crée le mouvement de la tête d'éclairage (1) est un moteur linéaire.

13. Dispositif selon la revendication 12,
**caractérisé par**
un capteur pour mesurer le flux lumineux et un circuit de régulation pour corriger les différences du flux lumineux par rapport à une valeur de consigne.

14. Dispositif selon la revendication 13,
**caractérisé en ce que**
le circuit de régulation comporte un dispositif d'actionnement pour modifier la durée d'exposition.

15. Dispositif selon l'une quelconque des revendications 13 ou 14,
**caractérisé en ce que**
le circuit de régulation comporte un dispositif d'actionnement pour modifier le flux lumineux.

16. Dispositif selon l'une quelconque des revendications 12 à 15,
**caractérisé par**
un moyen de fermeture pour commuter le courant électrique.

17. Dispositif selon la revendication 16,
**caractérisé en ce que**
l'unité générant les images (8) fonctionne comme le dispositif de coupure de l'éclairage.

18. Dispositif selon l'une quelconque des revendications 12 à 17,
**caractérisé par**
plusieurs têtes d'impression montées sur un même axe.

19. Dispositif selon la revendication 18,
**caractérisé par**
un moteur linéaire propre associé à chaque tête d'exposition (1) et pour l'autre axe, un moteur linéaire commun pour toutes les têtes d'exposition.
